# EUROPEAN PATENT APPLICATION

(11) **EP 3 166 081 A2**
(43) Date of publication of application: **10.05.2017**
(21) Application number: 16180206.1
(22) Date of filing: 19.07.2016
(51) Int. Cl.: G06T 19/00, G06T 7/70, G06F 3/01

(54) **METHOD AND SYSTEM FOR POSITIONING A VIRTUAL OBJECT IN A VIRTUAL SIMULATION ENVIRONMENT**

(30) Priority: 25.09.2015 US 201514866329
(71) Applicant: Siemens Industry Software Ltd., 7019900 Airport City (IL)
(72) Inventor: SCHWIMMER, Moshe, 5236109 Ramat-Gan (IL)
(74) Representative: Maier, Daniel Oliver

(57) **Abstract**

Systems and a method for positioning a virtual object, defined by a 3D model, in a virtual simulation environment include identifying a real object in a real environment from a 3D image of a 3D camera. The identified real object is linked to a corresponding virtual object. The location data of the position and orientation of the real object in the real scene is extracted. The extracted location data is used to position the linked virtual object at a specific virtual position and at a specific virtual orientation in the virtual scene reflecting the specific position and the specific orientation of the corresponding real object in the real scene.

## Description

### CROSS-REFERENCE TO OTHER APPLICATION

The present application has some subject matter in common with, but is not necessarily otherwise related to, commonly-assigned United States Patent Application Serial No. 14/865,226, titled: "METHOD AND SYSTEM FOR DETERMINING A CONFIGURATION OF A VIRTUAL ROBOT IN A VIRTUAL ENVIRONMENT" filed on the same day as the present patent document, which is incorporated by reference herein.

### TECHNICAL FIELD

The present disclosure is directed, in general, to computer-aided design, visualization, and manufacturing ("CAD") systems, product lifecycle management ("PLM") systems, product data management ("PDM") systems, and similar systems, that manage data for products and other items (collectively, "Product Data Management" systems or PDM systems).

### BACKGROUND OF THE DISCLOSURE

In the planning of industrial processes, computer simulation techniques are used where a physical scene of a physical environment is modeled by a virtual scene of a virtual simulation environment. The physical or real scene may, for example, be a facility, a manufacturing plant, an industrial scene, or any other physical scene that may benefit from being modeled in a virtual environment for industrial simulation purposes.

The real scene may include a variety of real objects that are related to a facility. Examples of real objects include, but are not limited to, equipment pieces, tools, containers, material pieces, finished or semi-finished products, and other objects present in the real scene. Real objects are represented in the virtual simulation environment by virtual objects. Virtual objects are typically defined through three-dimensional (3D) virtual models, examples of which include, but are not limited to, CAD models, CAD-like models, point cloud models, and other types of 3D computer models.

In the real scene, the real objects have a position and an orientation, which can change/move as the real object is moved or re-positioned within the real scene. When modeling industrial facilities in the virtual simulation environment, it is often a common requirement that the position and the orientation of the virtual objects in the virtual scene accurately reflect the position and the orientation of the real objects in the real scene. Unfortunately, it is difficult for users to create a 3D virtual scene reflecting the real world scene, even when the CAD data (which is modeling the virtual objects) may already be present. For example, when modeling industrial facilities, users often make use of CAD and CAD-like software tools to position and orientate virtual objects modeled via CAD or CAD-like models (herein, a virtual object modeled via a CAD or a CAD-like model is denoted with the term "CAD object").

For example, known techniques to reflect a real object in a virtual environment include making physical measurements of real objects and real scene in the real world environment, getting a point cloud data measurement from 3D scans, comparing CAD models to point cloud results, or mapping to two-dimensional (2D) measured maps in the virtual environment. Examples of techniques for positioning virtual objects in the virtual scene include classic human-machine interface ("HMI") systems, including standard input devices such as a keyboard, mouse, space mouse, leap motion for hand tracking, and the like. Unfortunately, such known techniques are tedious for the user, error prone, and may require multiple iterations with various tools or human interactions that make the known techniques ill-suited for the task. Therefore, improved techniques are desirable.

### SUMMARY OF THE DISCLOSURE

Various disclosed embodiments include methods and corresponding systems and computer-readable mediums for positioning a virtual object in a virtual simulation environment. A method includes: receiving a positioning of a 3D camera in a real scene; registering the 3D camera in a virtual simulation environment; receiving a positioning of at least one real object at a specific position and a specific orientation in the real scene; and, by the 3D camera, capturing at least one 3D image of the at least one real object positioned in the real scene. The method includes: identifying, from the at least one captured 3D image, the at least one real object; linking the at least one identified real object to its corresponding virtual object; and extracting location data of the specific position and of the specific orientation in the real scene of the at least one identified real object. The method includes, by using the extracted location data, positioning the linked virtual object at a specific virtual position and at a specific virtual orientation in the virtual scene reflecting the specific position and the specific orientation of the corresponding real object in the real scene.

The foregoing has outlined rather broadly the features and technical advantages of the present disclosure so that those skilled in the art may better understand the detailed description that follows. Additional features and advantages of the disclosure will be described hereinafter that form the subject of the claims. Those skilled in the art will appreciate that they may readily use the conception and the specific embodiment disclosed as a basis for modifying or designing other structures for carrying out the same purposes of the present disclosure. Those skilled in the art will also realize that such equivalent constructions do not depart from the spirit and scope of the disclosure in its broadest form.

Before undertaking the DETAILED DESCRIPTION below, it may be advantageous to set forth definitions of certain words or phrases used throughout this patent document: the terms "include" and "comprise," as well as derivatives thereof, provide inclusion without limitation; the term "or" is inclusive (e.g., and/or); the phrases "associated with" and "associated therewith," as well as derivatives thereof, may be to include, be included within, interconnect with, contain, be contained within, connect to or with, couple to or with, be communicable with, cooperate with, interleave, juxtapose, be proximate to, be bound to or with, have, have a property of, or the like; and the term "controller" is any device, system or part thereof that controls at least one operation, whether such a device is implemented in hardware, firmware, software or some combination of at least two of the same. It should be noted that the functionality associated with any particular controller may be centralized or distributed, whether locally or remotely. Definitions for certain words and phrases are provided throughout this patent document, and those of ordinary skill in the art will understand that such definitions apply in many, if not most, instances to prior as well as future uses of such defined words and phrases. While some terms may include a wide variety of embodiments, the appended claims may expressly limit these terms to specific embodiments.

### BRIEF DESCRIPTION OF THE DRAWINGS

For a more complete understanding of the present disclosure, and the advantages thereof, reference is now made to the following descriptions taken in conjunction with the accompanying drawings, wherein like numbers designate like objects, and in which:
Figure 1 illustrates a block diagram of a data processing system in which an embodiment can be implemented;
Figure 2 illustrates a first schematic view of a virtual object in a virtual simulation environment reflecting the position and the orientation of a real object in accordance with a disclosed example embodiment;
Figure 3 illustrates a second schematic view of a virtual object in a virtual simulation environment reflecting the position and the orientation of a real object in accordance with a disclosed example embodiment;
Figure 4 illustrates a flowchart of a process for positioning a virtual object in a virtual simulation in accordance with disclosed embodiments.

### DETAILED DESCRIPTION

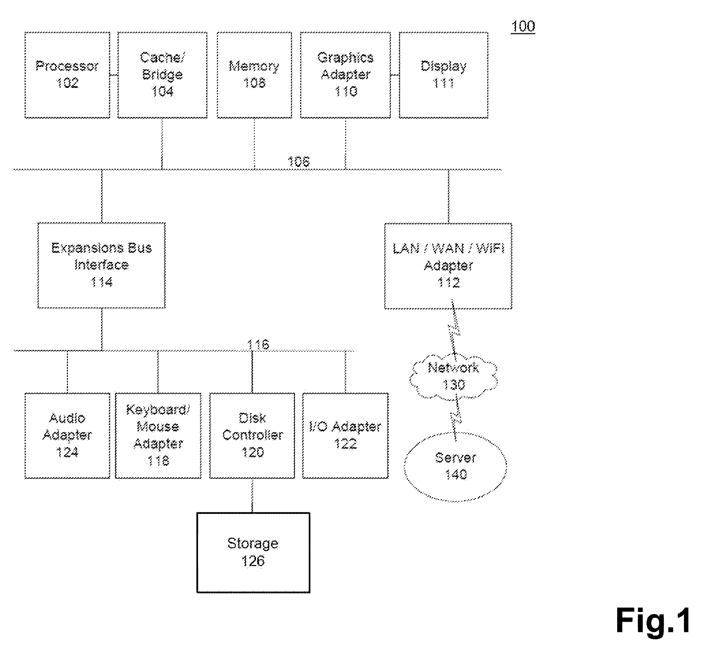

FIGURES 1 through 4, discussed below, and the various embodiments used to describe the principles of the present disclosure in this patent document are by way of illustration only and should not be construed in any way to limit the scope of the disclosure. Those skilled in the art will understand that the principles of the present disclosure may be implemented in any suitably arranged device. The numerous innovative teachings of the present application will be described with reference to exemplary non-limiting embodiments.

Previous techniques based on the use of classic HMI for controlling the virtual position and the virtual orientation of virtual objects are cumbersome, tedious, error-prone, and otherwise ill-suited for the task. Moreover, for example, previous techniques based on point cloud scans may be relevant to a single point of time and are not dynamic.

Embodiments provide numerous benefits including, but not limited to: providing a user-friendly manner for modeling or for performing modification of the virtual scenes of the simulation environment; enabling a user-friendly control of the position and of the orientation of virtual objects in an intuitive manner so that the industrial simulation and planning is done as it was in the real world; facilitating, for non-expert users, the usage of industrial simulation packages on a shop floor (such as Process Simulate and Human Simulation provided by Siemens Product Lifecycle Management Software Inc. (Plano, Texas)) to execute the virtual simulation for ongoing production simulation.

Embodiments may be particularly beneficial for software packages that incorporate CAD environments, including, but not limited to, NX, Process Simulate, Solid Edge, and others provided by Siemens Product Lifecycle Management Software Inc. (Plano, Texas) or packages offered by other software suppliers. Embodiments combined with a CAD system may conveniently supply a complete design and simulation environment.

Figure 1 illustrates a block diagram of a data processing system 100 in which an embodiment can be implemented, for example, as a PDM system particularly configured by software or otherwise to perform the processes as described herein, and, in particular, as each one of a plurality of interconnected and communicating systems as described herein. The data processing system 100 illustrated can include a processor 102 connected to a level two cache/bridge 104, which is connected in turn to a local system bus 106. Local system bus 106 may be, for example, a peripheral component interconnect (PCI) architecture bus. Also connected to local system bus in the illustrated example are a main memory 108 and a graphics adapter 110. The graphics adapter 110 may be connected to display 111.

Other peripherals, such as local area network (LAN) / Wide Area Network / Wireless (e.g., WiFi) adapter 112, may also be connected to local system bus 106. Expansion bus interface 114 connects local system bus 106 to input/output (I/O) bus 116. I/O bus 116 is connected to keyboard/mouse adapter 118, disk controller 120, and I/O adapter 122. Disk controller 120 can be connected to a storage 126. The storage 126 can be any suitable machine usable or machine readable storage medium, including but not limited to nonvolatile, hard-coded type mediums such as read only memories (ROMs) or erasable, electrically programmable read only memories (EEPROMs), magnetic tape storage, and user-recordable type mediums such as floppy disks, hard disk drives and compact disk read only memories (CD-ROMs) or digital versatile disks (DVDs), and other known optical, electrical, or magnetic storage devices.

Also connected to I/O bus 116 in the example shown is audio adapter 124, to which speakers (not shown) may be connected for playing sounds. Keyboard/mouse adapter 118 provides a connection for a pointing device (not shown), such as a mouse, trackball, trackpointer, touchscreen, etc.

Those of ordinary skill in the art will appreciate that the hardware illustrated in Figure 1 may vary for particular implementations. For example, other peripheral devices, such as an optical disk drive and the like, also may be used in addition or in place of the hardware illustrated. The illustrated example is provided for the purpose of explanation only and is not to imply architectural limitations with respect to the present disclosure.

A data processing system in accordance with an embodiment of the present disclosure can include an operating system employing a graphical user interface. The operating system permits multiple display windows to be presented in the graphical user interface simultaneously, with each display window providing an interface to a different application or to a different instance of the same application. A cursor in the graphical user interface may be manipulated by a user through the pointing device. The position of the cursor may be changed and/or an event, such as clicking a mouse button, generated to actuate a desired response.

One of various commercial operating systems, such as a version of Microsoft Windows™, a product of Microsoft Corporation located in Redmond, Wash., may be employed if suitably modified. The operating system is modified or created in accordance with the present disclosure as described.

LAN/ WAN/Wireless adapter 112 can be connected to a network 130 (not a part of data processing system 100), which can be any public or private data processing system network or combination of networks, as known to those of skill in the art, including the Internet. Data processing system 100 can communicate over network 130 with server system 140, which is also not part of data processing system 100, but can be implemented, for example, as a separate data processing system 100.

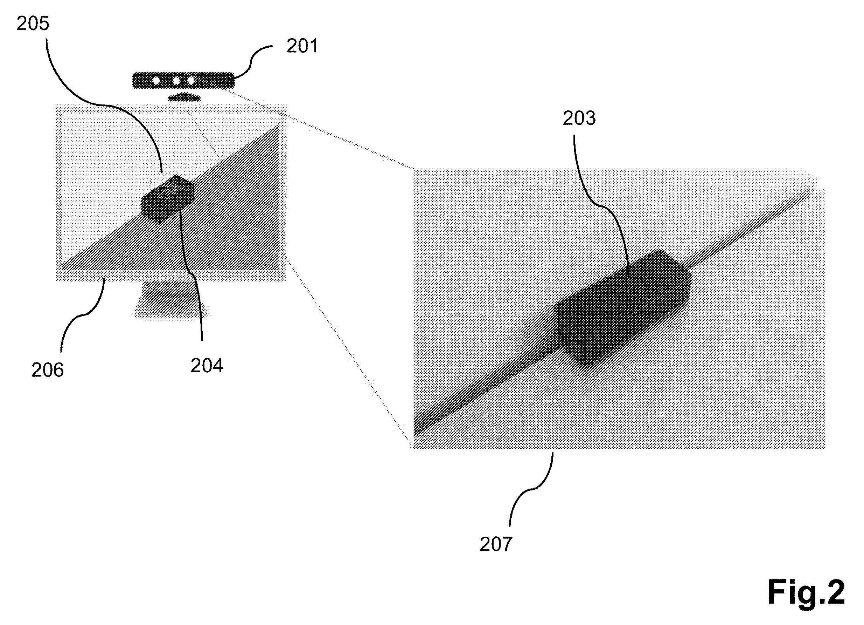

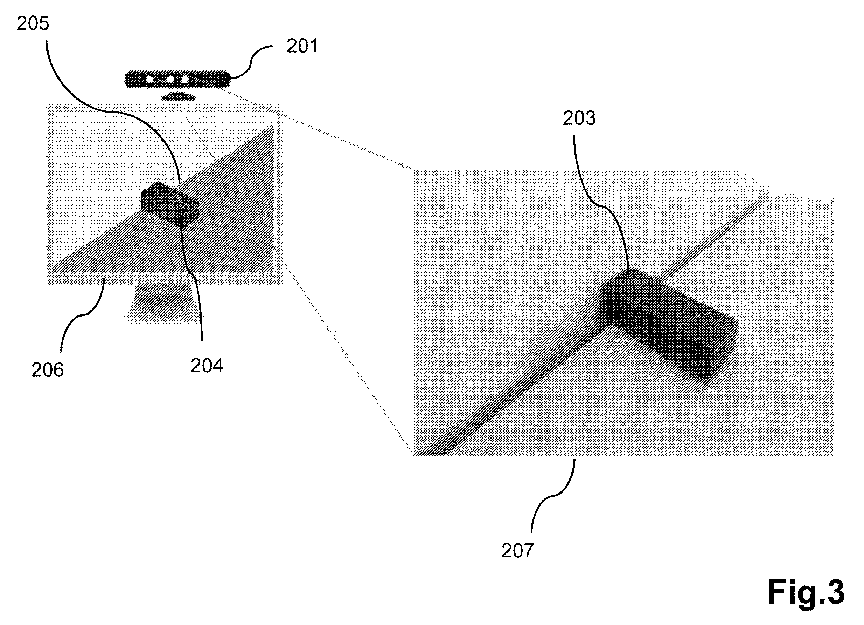

Figures 2 and 3, respectively, illustrate a schematic first view and a schematic second view of a virtual object in a virtual simulation environment reflecting the position and the orientation of a real object in accordance with disclosed example embodiments.

A virtual object 204 is available in a virtual environment 206. The virtual environment is already populated with one or more virtual objects 204 reflecting one or more real objects 203 of a real environment 207. Figures 2 and 3 illustrate an exemplary embodiment where one of such objects is captured by a 3D camera 201.

Those skilled in the art recognize that, in other embodiments, a plurality of different real objects 203 may simultaneously be captured by the 3D camera 201 and identified accordingly. For the set of virtual objects 204 available for the virtual environment, a corresponding set of 3D virtual models is provided within the system. The set of 3D virtual models may be provided from a variety of different sources including, but not limited to, a virtual simulation environment, a CAD library, a CAD software connected to the virtual simulation environment, by point cloud scans, by 2D image scans, mechanical scans, manual scans and other sources. A CAD model is a particular type of 3D virtual model and in the exemplary embodiment illustrated in Figures 2 and 3, the virtual object 204 may be a CAD object when the 3D virtual model is a CAD model.

The 3D camera 201 is located in the physical scene and is registered in the virtual world to provide a consistent offset by defining the 3D camera position and orientation in the virtual scene. After the 3D camera 201 has captured at least one 3D image of the real object 203, the real object 203 is identified. The identified real object 203 is linked to the corresponding virtual object 204. As used herein, the term "3D image" is used to denote, for simplicity purposes, a set or stream of frames from the 3D camera.

In some embodiments, the linking between the real object 203 and the corresponding virtual object 204 may be adapted to be done manually by a user. In other embodiments, the linking may be done by automatic recognition via *picking.* For example, in an exemplary scenario, where the simulation environment is provided with three (or any number) different virtual objects of different sizes, once a real object is identified, the linking (i.e., the choice among the three virtual objects) may be done through automatic recognition (e.g., by picking the virtual object associated with a given 3D scan). In such a latter case, the software is able to link the 3D camera image to the specific CAD object having a given 3D scan.

In some embodiments, the relevant CAD models may be taken from an existing CAD library. By extracting location data on the position and orientation of the real object in the real scene, the virtual object 204 is calibrated according to the real object 203 so that the virtual object 204 is positioned in a virtual position and virtual orientation that reflect the real position and real orientation of the corresponding real object 203 in the real scene 207. As illustrated in the figures, the virtual object 204 in Figure 3 has a different position and orientation from the virtual object 204 of Figure 2, which reflects the position and orientation change of the real object 203. In some embodiments, the position and orientation of a 3D object may be manipulated by a manipulator 205 to correspond to a graphical representation of the position and orientation of the virtual object.

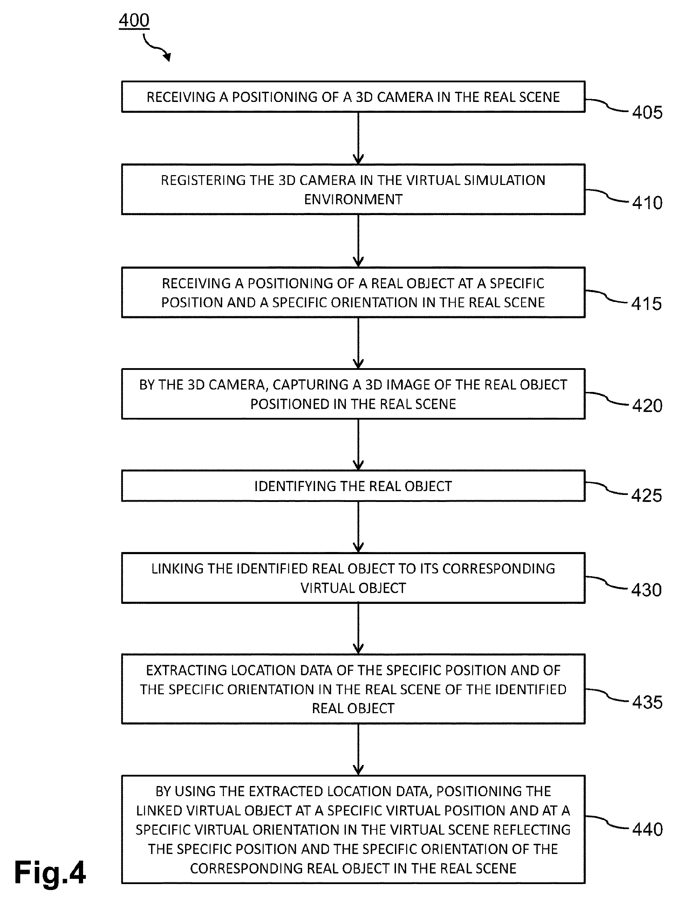

Figure 4 illustrates a flowchart 400 of a process for positioning a virtual object in a virtual environment in accordance with disclosed embodiments. Such a process can be performed, for example, by system 100 of Figure 1 described above, but the "system" in the process below can be any apparatus configured to perform a process as described.

The virtual simulation environment includes a virtual scene reflecting a real scene of a real environment. At least one virtual object representing at least one real object of the real environment is provided, the virtual object defined by a 3D virtual model.

At act 405, a positioning of a 3D camera in the real scene is received.

At act 410, the 3D camera is registered in the virtual simulation environment so that there is a calibration between the real scene and the virtual scene.

At act 415, a positioning of at least one real object at a specific position and a specific orientation in the real scene is received.

At act 420, the 3D camera captures at least one 3D image of the at least one real object positioned in the real scene.

At act 425, the at least one real object is identified from the at least one captured 3D image.

At act 430, the at least one identified real object is linked to its corresponding virtual object.

At act 435, location data of the specific position and of the specific orientation in the real scene of the at least one identified real object is extracted.

At act 440, the linked virtual object is positioned, by using the extracted location data, at a specific virtual position and at a specific virtual orientation in the virtual scene reflecting the specific position and the specific orientation of the corresponding real object in the real scene.

In some embodiments, the position and the orientation of the identified real object is varied, and the corresponding linked virtual object is positioned with a position and an orientation to reflect these variations by repeating acts 420, 435 and 440 accordingly. Through such embodiments, a dynamic update may advantageously be provided. With such embodiments, any movement of the real object in the real scene may influence the position and the orientation of the virtual object in the virtual scene so that, in a connected system, movements between real objects and virtual objects are synchronized, also in real time.

One or more of the processor 102, the memory 108, and the simulation program running on the processor 102 receive the inputs via one or more of the local system bus 106, the adapter 112, the network 130, the server 140, the interface 114, the I/O bus 116, the disk controller 120, the storage 126, and so on. Receiving, as used herein, can include retrieving from storage 126, receiving from another device or process, receiving via an interaction with a user, or otherwise.

Of course, those of skill in the art will recognize that, unless specifically indicated or required by the sequence of operations, certain acts in the processes described above may be omitted, performed concurrently or sequentially, or performed in a different order.

Those skilled in the art will recognize that, for simplicity and clarity, the full structure and operation of all data processing systems suitable for use with the present disclosure is not being illustrated or described herein. Instead, only so much of a data processing system as is unique to the present disclosure or necessary for an understanding of the present disclosure is illustrated and described. The remainder of the construction and operation of data processing system 100 may conform to any of the various current implementations and practices known in the art.

It is important to note that while the disclosure includes a description in the context of a fully functional system, those skilled in the art will appreciate that at least portions of the mechanism of the present disclosure are capable of being distributed in the form of instructions contained within a machine-usable, computer-usable, or computer-readable medium in any of a variety of forms, and that the present disclosure applies equally regardless of the particular type of instruction or signal bearing medium or storage medium utilized to actually carry out the distribution. Examples of machine usable/readable or computer usable/readable mediums include: nonvolatile, hard-coded type mediums such as read only memories (ROMs) or erasable, electrically programmable read only memories (EEPROMs), and user-recordable type mediums such as floppy disks, hard disk drives and compact disk read only memories (CD-ROMs) or digital versatile disks (DVDs).

Although an exemplary embodiment of the present disclosure has been described in detail, those skilled in the art will understand that various changes, substitutions, variations, and improvements disclosed herein may be made without departing from the spirit and scope of the disclosure in its broadest form.

None of the description in the present application should be read as implying that any particular element, act, or function is an essential element that must be included in the claim scope: the scope of patented subject matter is defined only by the allowed claims.

## Claims

1. A method for positioning a virtual object in a virtual simulation environment by a data processing system, wherein the virtual simulation environment comprises a virtual scene reflecting a real scene of a real environment, and wherein the virtual simulation environment is provided at least one virtual object representing at least one real object of the real environment, the at least one virtual object being defined by a 3D three-dimensional virtual model, the method comprising:
receiving (405) a positioning of a 3D camera (201) in the real scene;
registering (410) the 3D camera (201) in the virtual simulation environment (206);
receiving a positioning (415) of a real object (203) at a specific position and a specific orientation in the real scene;
capturing (420), by the 3D camera (201), at least one 3D image of the real object (203) positioned in the real scene;
identifying (425), from the at least one captured 3D image, the real object (203);
linking (430) the identified real object (203) to a corresponding virtual object (204);
extracting location data (435) of the specific position and of the specific orientation in the real scene of the identified real object (203);
positioning (440) the linked virtual object (204) at a specific virtual position and at a specific virtual orientation in the virtual scene reflecting the specific position and the specific orientation of the corresponding real object (203) in the real scene, the positioning comprising using the extracted location data.

2. The method of claim 1, wherein the 3D virtual model is selected from the group consisting of:
computer aided design (CAD) model;
CAD-like model;
point cloud model; and
3D computer model.

3. The method of any of the previous claims, further comprising:
receiving a variation of positioning of the specific position and of the specific orientation of the real object (203);
repeating steps the capturing, the extracting, and the positioning so as to reposition the linked virtual object (204) at a specific second virtual position and at a specific second virtual orientation in the virtual scene reflecting a specific second position and a specific second orientation of the corresponding real object (203) in the real scene.

4. The method of any of the previous claims, wherein the real object is selected from the group consisting of:
a piece of equipment;
a tool;
a piece of material;
a semi-finished product; and
a finished product.

5. The method of any of the previous claims, where the capturing is performed automatically via picking.

6. The method of any of the previous claims, where the capturing is adapted to be performed manually.

7. A data processing system comprising:
a processor; and
an accessible memory, the data processing system configured to:
receive a positioning of a three-dimensional (3D) camera in a real scene;
register the 3D camera (201) in a virtual simulation environment;
receive a positioning of at least one real object (203) at a specific position and a specific orientation in the real scene;
receive inputs, by the 3D camera (201), of a capturing of at least one 3D image of the at least one real object positioned (203) in the real scene;
identify, from the at least one captured 3D image, the at least one real object (203);
link the at least one identified real object (203) to a corresponding virtual object (204) defined by a 3D virtual model;
receive inputs of extracted location data of the specific position and of the specific orientation in the real scene of the at least one identified real object (204);
position, using the extracted location data, the linked virtual object (204) at a specific virtual position and at a specific virtual orientation in the virtual scene reflecting the specific position and the specific orientation of the corresponding real object (203) in the real scene.

8. The data processing system of claim 7, wherein the 3D virtual model is selected from the group consisting of:
computer-aided design (CAD) model;
CAD-like model;
point cloud model; and
3D computer model.

9. The data processing system of claim 7 or 8, wherein the real object is selected from the group consisting of:
a piece of equipment;
a tool;
a piece of material;
a semi-finished product; and
a finished product.

10. A non-transitory computer-readable medium encoded with executable instructions that, when executed, cause one or more data processing systems to:
receive a positioning of a three-dimensional 3D camera (201) in a real scene;
register the 3D camera (201) in a virtual simulation environment;
receive a positioning of at least one real object (203) at a specific position and a specific orientation in the real scene;
receive inputs, by the 3D camera (201), of a capturing of at least one 3D image of the at least one real object (203) positioned in the real scene;
identify, from the at least one captured 3D image, the at least one real object (203);
link the at least one identified real object (203) to a corresponding virtual object (204) defined by a 3D virtual model;
receive inputs of extracted location data of the specific position and of the specific orientation in the real scene of the at least one identified real object (204);
position, using the extracted location data, the linked virtual object (204) at a specific virtual position and at a specific virtual orientation in the virtual scene reflecting the specific position and the specific orientation of the corresponding real object (203) in the real scene.

11. The non-transitory computer-readable medium of claim 10, wherein the 3D virtual model is selected from the group consisting of:
computer-aided design (CAD) model;
CAD-like model;
point cloud model; and
3D computer model.

12. The non-transitory computer-readable medium of claim 10 or 11, wherein the real object is selected from the group consisting of:
a piece of equipment;
a tool;
a piece of material;
a semi-finished product; and
a finished product.
